Europäisches Patentamt

(19) European Patent Office

Office européen des brevets

(11) Publication number: 0 273 702
A2

# EUROPEAN PATENT APPLICATION

(21) Application number: 87311350.0

(22) Date of filing: 23.12.87

(51) Int. Cl.⁴: H 01 L 27/10
H 01 L 21/54

(30) Priority: 29.12.86 US 947160

(43) Date of publication of application:
06.07.88 Bulletin 88/27

(84) Designated Contracting States: DE FR GB IT NL

(71) Applicant: GENERAL ELECTRIC COMPANY
1, River Road
Schenectady New York 12345 (US)

(72) Inventor: Wei, Ching-Yeu
14 Sussex Way
Schenectady New York 12309 (US)

Woodbury, Henry Hugh
1008 Tecumseh Way
Scotia New York 12302 (US)

(74) Representative: Smith, Thomas Ian Macdonald et al
GE/RCA Patent Operation Burdett House, 4th Floor 15-16
Buckingham Street
London WC2N 6DU (GB)

(54) Radiation hardening techniques for metal-oxide silicon devices.

(57) Techniques for improving the radiation hardness of CMOS VLSI devices manufactured using a standard commercial process are disclosed. The techniques include a boron bird's beak implant after a field oxide is grown by the LOCOS process. The radiation hardness of the devices is further enhanced by a bird's beak etch to form a self-aligned guard ring.

Fig. 1

**Description**

## RADIATION HARDENING TECHNIQUES FOR METAL-OXIDE SILICON DEVICES

The present invention generally relates to techniques for radiation hardening metal oxide silicon (MOS) devices and, more particularly, to techniques for radiation hardening commercial VLSI (very large scale integrated) circuits having field oxides grown using the LOCOS (local oxidation of silicon) process for field isolation. The techniques according to the invention include bird's beak radiation hardening by implantation and the use of a bird's beak etch.

Recently, considerable attention has been given to the radiation hardening of commercial VLSI MOS devices to a total dose of 200 kilorads for space systems applications. The reasons for this are that such long term, low dose rate space missions require only a moderate total dose radiation hardness which should be achievable in a commercial process, and a commercial process generally requires high yield and low cost. High yield in commercial processes is particularly important as the circuit functions become more complex and the chip sizes get larger.

It is known that most commercial NMOS (N-channel metal oxide silicon) and CMOS (complementary metal oxide silicon) devices are not radiation hard. It is also known that the major reason for such lack of radiation hardness is the presence of the field oxide grown by the LOCOS process. For a description of the LOCOS process of oxide isolation, the reader is referred to VLSI Electronics, Microstructure Science, Volume 12, "Silicon Materials", edited by Norman G. Einspruch and Howard Huff, published by Academic Press, New York (1985), pages 149 and 150. Most commercial CMOS devices are fabricated using the LOCOS process for field isolation because of the accumulated experience and confidence in this isolation technology among integrated circuit houses. NMOS transistors fabricated by using this isolation process are, however, known to be "rad-hard soft"; i.e., they show leakage current with less than 10 kilorads irradiation. It is also known that inversion of the field oxide and the oxide in the "bird's beak" region, defined below, is the major source of leakage current.

Formation of the local oxide is accompanied by the phenomenon known as "bird's beak" in which there is an oxide thickness beginning beneath the edge of silicon nitride pads atop the field region and continuously increasing in thickness beneath the pads with increasing distance from the edge. This phenomenon results from lateral oxidation. A further explanation of this phenomenon may be found in the aforementioned volume 12 of the treatise on VLSI Electronics at page 150. Furnishing a guardband or gap of P+ conductivity semiconductor extending about 3 microns from the source and drain junctions to the edge of the active area, or tip of the bird's beak, has been shown to be effective in eliminating the leakage current problem in NMOS devices. This guardband, however, is at the expense of making design rule changes and reducing circuit density, and also introduces processing complexities. In particular, such band or gap can severely reduce the circuit density when 1.2μm VLSI design rules are used. Both of these approaches, so far, have been used only in 3 μm CMOS process.

It is therefore an object of this invention to provide new radiation hardening techniques for VLSI MOS devices using the LOCOS isolation process, that are adaptable to commercial processes of manufacture of such devices.

According to one embodiment of the invention, a bird's beak implant is used to raise the threshold voltage beneath the bird's beak region. This implant is performed using 250 keV boron ions. As a result, the concentration of boron atoms in the bird's beak region is raised from a low $10^{16} cm^{-3}$ to the $10^{17} cm^{-3}$ range. The concentration of boron atoms in the field oxide region is also raised from about 2.8 $\times 10^{17} cm^{-3}$ to 9 $\times 10^{17} cm^{-3}$, thereby increasing the field threshold voltage from 22 volts to 90 volts. With the bird's beak implant and a P-well implant, the boron concentration is significantly raised everywhere except in the active area, and hence the threshold voltage change for an NMOS transistor fabricated by this technique is minimal. However, these implants alone only improve the radiation hardness of NMOS transistors by 10 to 20 kilorads. While this fact was initially puzzling, it is now understood that the increased P-well implant and the added bird's beak implant serve to radiation harden the field oxide and most of the bird's beak except for a small region adjacent to the active area. This small region benefits from neither of these implants. It has been discovered, however, that etching away some, for example 1000Å to 2000Å, of the field oxide after performing the bird's beak implant significantly increases radiation hardness of the transistors being fabricated. This etching step removes the tip of the bird's beak, and the newly formed active area surrounding the original active area, as a result of the etch, can be considered a self-aligned guard ring with a higher threshold voltage than the rest of the device.

The techniques according to the present invention are particularly attractive because they are performable using standard VLSI processing techniques. The trade-off is an increase in junction capacitance due to the increased P-well dopant concentration resulting from the bird's beak implant. The increase in junction capacitance can be minimized by using a non-critical mask so that only the bird's beak regions near both ends of the polysilicon gate are exposed to the implant. Radiation hardness as high as 80 kilorads at the transistor level has been obtained by use of the invention.

The foregoing and other objects, aspects and advantages of the invention will be better understood from the following detailed description of the invention with reference to the drawings, in which:

Figure 1 is a cutaway illustration of an NMOS transistor showing the bird's beak region;

Figures 2A and 2B are contour maps of the boron doping in a P-well NMOS transistor without a bird's beak implant and with a bird's beak implant, respectively;

Figure 3 is a contour map showing the boron doping along the silicon dioxide-silicon (or $SiO_2$-Si) interface in the field oxide and bird's beak regions;

Figure 4 is a cross-sectional illustration of the field oxide, grown by the LOCOS process, showing the result of the bird's beak etch;

Figure 5 is a graph of NMOS threshold voltage as a function of bird's beak implant energy;

Figure 6 is a cross-sectional illustration of the pre-gettered epitaxial starting material used for making test devices;

Figure 7 is a cross-sectional illustration of a silicon substrate with mesas of silicon nitride and resist material for defining the field regions;

Figure 8 is a cross-sectional view showing the silicon substrate of Figure 7 after the field regions have undergone oxidation by a LOCOS process, with the photoresist and nitride layers removed;

Figure 9 is a cross-sectional view showing the silicon substrate of Figure 8 during implantation with retrograde P-well and bird's beak implants;

Figure 10 is a cross-sectional view of the test device after undergoing the implantation process shown in Figure 8, where the device is being implanted with PMOS punch through the PMOS threshold adjust implants;

Figure 11 is a top plan view showing a mask layout which may be used during the boron implant shown in Figure 9;

Figure 12 is a cross-sectional illustration showing location of the gate electrodes on the test device undergoing fabrication;

Figure 13 is a cross-sectional illustration showing location of the resist masks used to define location of the source and drain regions in the NMOS portion of the test device and the drain regions in the PMOS portion of the test device;

Figure 14 is a cross-sectional illustration of the test device while undergoing implantation with NMOS lightly doped drain implants;

Figure 15 is a cross-sectional view of the test device after the deposition of $SiO_2$ for making polysilicon sidewall spacers;

Figure 16 is a cross-sectional view of the test device after reactive ion etching of the deposited $SiO_2$;

Figure 17 is a cross-sectional illustration of the test device while undergoing implantation with an NMOS source/drain implant;

Figure 18 is a cross-sectional illustration of the test device while undergoing implantation with a PMOS source/drain implant;

Figure 19 is a cross-sectional illustration of the test device after an interlevel dielectric has been applied and etched by reactive ion etching down to the source and drain regions.

Figure 20 is a cross-sectional view of the test device after the first metallization has been applied;

Figure 21 is a cross-sectional view of the test device after the intermetal dielectric and the spin coated planarization resist have been applied;

Figure 22 is a cross-sectional view of the test device after the resist has been etched and a layer of $SiO_2$ has been added;

Figure 23 is a cross-sectional view of the test device after via formation; and

Figure 24 is a cross-sectional view of the test device after the second metallization and a deposition of protective oxide have been applied.

When a CMOS device is exposed to ionizing radiation such as gamma-rays, electron-hole pairs are generated in both the thin gate oxide and the thick field oxide, giving rise to oxide-trapped charges and the generation of interface states. The net result of these effects is to cause a negative shift in the gate and field threshold voltages. Consequently, NMOS transistors become more leaky, while PMOS (P-channel) transistors become harder to turn on, leading eventually to functional failure of the CMOS device. However, the NMOS transistors are more of a concern than the PMOS transistors since the magnitudes of the shifts are larger in NMOS transistors and such shifts can result in excessive power dissipation before circuit failure occurs.

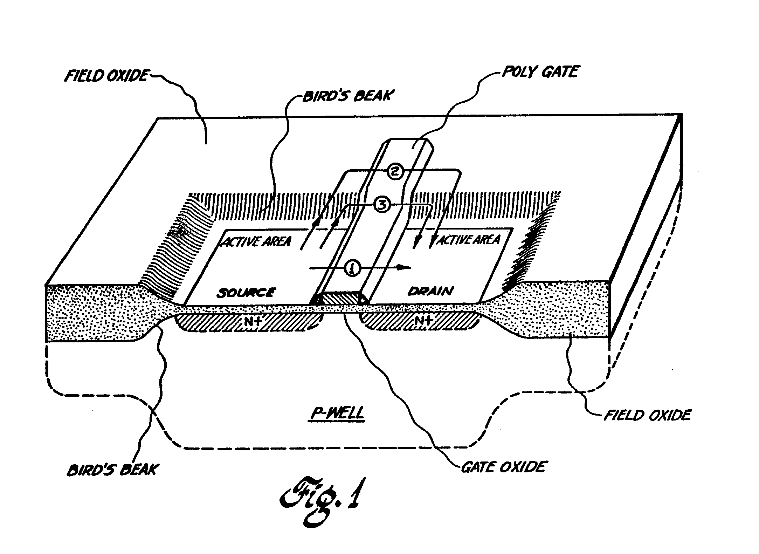

As mentioned, NMOS transistors using the LOCOS field isolation are known to show leakage current with less than 10 kilorads irradiation. For convenience in understanding the leakage current mechanisms, an NMOS transistor may be considered to be divided into the three areas shown in Figure 1. These areas are the active area, the full thickness field oxide area, and the in-between or bird's beak area. The active area is indicated as the silicon mesa on which the transistor device is located. Leakage can result from threshold voltage shifts in each of these areas, namely threshold voltage shifts of the gate oxide, surface inversion of the field oxide, and/or surface inversion in the bird's beak region. The elimination of nitrogen molecules during the ramp-down sequence of the field oxidation cycle has been shown to reduce radiation sensitivity.

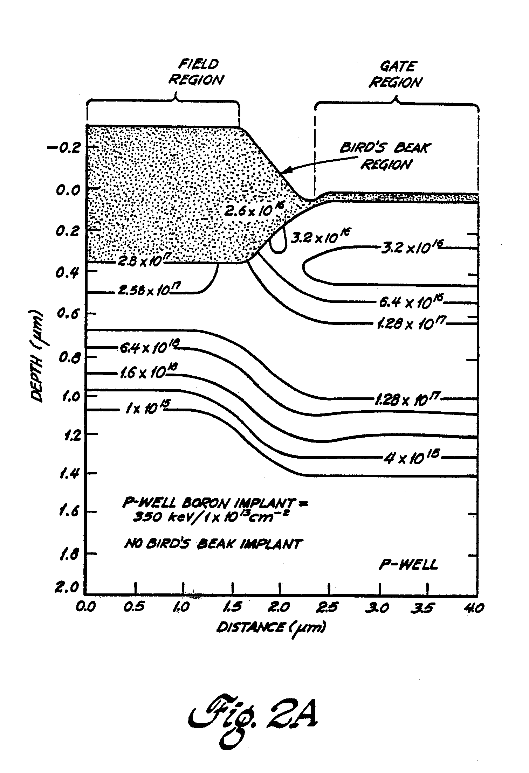

The bird's beak region in the LOCOS process is the most critical area with respect to radiation hardness. It is also the most difficult to understand. Since there is no simple way to directly probe this region, process simulation programs were used to model it so that qualitative predictions of its behavior under irradiation could be made. Figure 2A, for example, is a contour map of the boron doping in a typical retrograde P-well NMOS transistor as simulated. The boron contours represent constant concentrations in atoms/$cm^3$. A retrograde well is formed by high energy ion implantation after field oxidation has taken place. Shape of the implant impurity profile is maintained in the subsequent processing steps by avoidance of high temperature processing. Since the peak of the profile is below the surface, the well is termed "retrograde" to emphasize the rise and fall of the concentration versus depth. For a description of the retrograde P-well process for implanting boron ions, the reader is referred to the paper presented by Stephen R. Combs, entitled "Scaleable Retrograde P-Well CMOS Technology", at the International Electronic Devices Meeting (IEDM) IN 1981. It will be observed, from Figure 2A, that the boron concentration underneath the bird's beak is generally less than it is in the gate region and field region other than the bird's beak region. This results directly from the retrograde P-well and the threshold-adjust implants. The former uses 350 keV boron ions resulting in an implant depth of about 0.8 $\mu$m, as shown in Figure 2A, whereas the latter uses 45 keV boron ions having an implant depth of about 0.1 $\mu$m. At a depth of 0.3 $\mu$m in the bird's beak region, there are simply not enough boron ions from either implant to properly control the threshold voltage. In a non-irradiation environment, which includes most commercial applications, the threshold voltage in this part of the bird's beak region appears to be adequate, although marginal. Because of the widely varying thickness of the oxide in the birds beak region and the strong dependence of the radiation-induced threshold shift on oxide thickness, this already marginal threshold voltage can no longer accommodate the large threshold voltage shifts induced by radiation. Parasitic leakage channels between the source and drain quickly form when undergoing 10 kilorads or less of radiation as the surface underneath the bird's beak becomes inverted. The radiation inverts the oxide to permit the current to pass through the oxide. Three types of parasitic leakage channels which short between source and drain are formed, as shown in Figure 1. Thus, channel 1 is a conductive channel underneath the polysilicon gate and the gate oxide, channel 2 is a conductive channel under the thick field oxide, and channel 3 is a conductive channel under the oxide in the bird's beak region.

One way to radiation-harden the bird's beak region is to raise the threshold voltage. This has been accomplished by a "bird's beak" implant using 250 keV boron ions. Figure 2B is a simulated contour map of the boron doping that would result from such an implant plus the P-well implant. The boron doping concentration in the bird's region is now significantly raised into the $10^{17}$ ions/cm$^3$ range. Using a computer simulation of the boron doping profile and threshold changes in the active area, the energy and magnitude of the bird's beak implant were optimized for a minimum acceptable threshold voltage change in the active area. The principal difficulty encountered was a lowering of the source and drain junction breakdown voltage which limited the maximum bird's beak implant doping dosage to the low $10^3$ ions/cm$^2$ range.

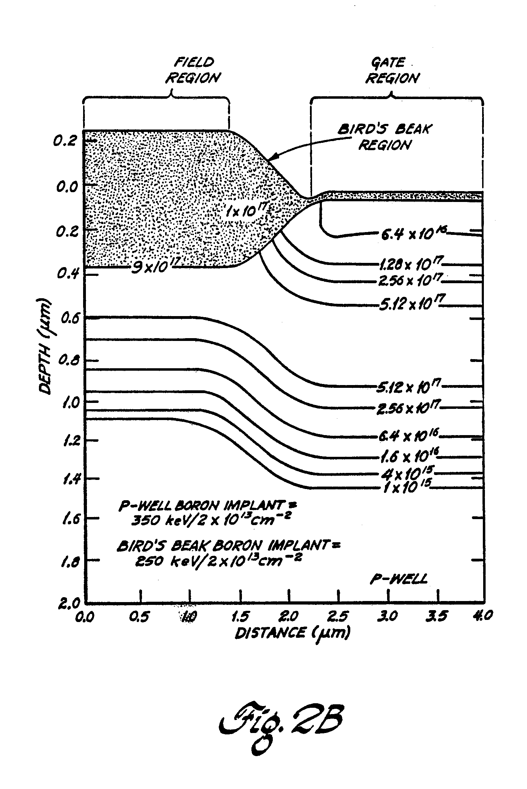

To further illustrate the principal points described above, the boron concentration along the silicon-silicon dioxide interface in the field oxide and bird's beak regions shown in Figures 2A and 2B are replotted in Figure 3 along the same distance abscissa. It should be noted that the full CMOS process was employed in all of these simulations.

The dashed line in Figure 3 shows the simulated boron concentration in the field oxide and bird's beak regions of an NMOS transistor without the bird's beak implant. The boron concentration of about $2.8 \times 10^{17}$ ions/cm$^3$ in the field oxide region corresponds to the observed field threshold voltage of about 22 volts. The depletion in the boron concentration underneath the bird's beak is also evident.

With the bird's beak implant dosage (250 keV/ B$^+$ /2 $\times$ 10$^{13}$/cm$^2$) and the P-well implant, the boron concentration is significantly raised everywhere, except for the active area, as illustrated by the solid curve in Figure 3. Because the boron concentration in the active area remains unchanged, the threshold voltage change of the final NMOS transistor, without some additional intervention, would be minimal. In general, the P-well implant is made to be as deep as possible to minimize substrate-bias effects, whereas the bird's beak implant is made as shallow as possible to minimize radiation-induced bird's beak leakage current at the tip, although not so shallow as to change the threshold voltage in the active region.

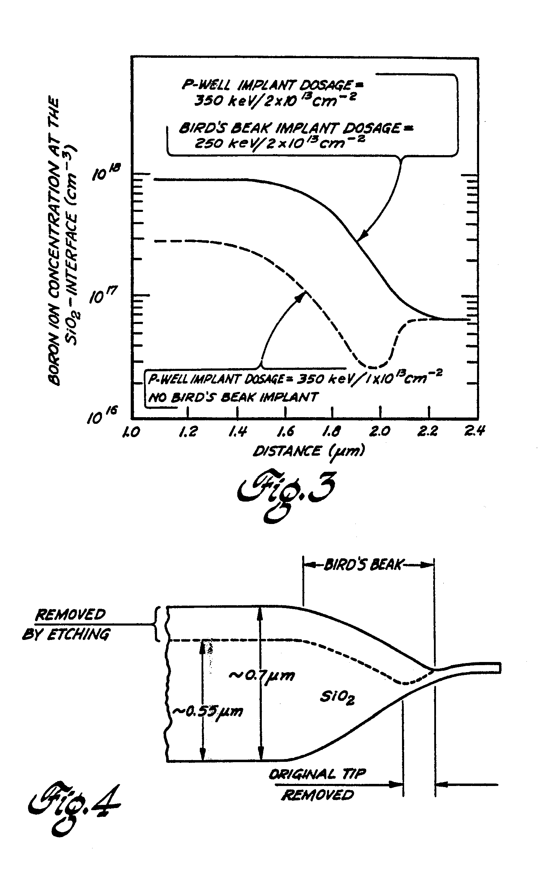

These implants alone only improve the radiation hardness of NMOS transistors by 10 to 20 kilorads. However, as shown in Figure 3, the P-well implant and the added bird's beak implant raise the boron ion concentration at, and hence serve to radiation harden, the field oxide and most of the bird's beak except for a small region adjacent to the active area. This small region, between 2.1 $\mu$m and 2.2 $\mu$m along the distance scale as shown in Figure 3, constitutes the tip of the bird's beak and benefits from neither of these implants. However, etching away 1000Å to 2000Å of the field oxide following the bird's beak implant significantly increases radiation hardness of the transistors. This etching step removes the original tip of the bird's beak, as indicated by the dashed line in Figure 4, and will be referred to hereinafter as the "bird's beak etch". The newly formed active area surrounding the original active area, as a result of the etch, can be considered a self-aligned guard ring with a higher threshold.

The retrograde P-well process using boron ion implantation lends itself to this simple way of radiation hardening the field oxide and bird's beak. Using the extra boron implant or increasing the P-well implant would be prohibitive in other N-well or P-well CMOS processes. For example, in a typical N-well process, the field threshold voltage of the NMOS device is controlled by the field boron implant before field oxidation. Because of the incorporation of boron atoms in the oxide during the field oxidation and the fast diffusion of boron in the silicon substrate, it has been found ineffective or impractical to raise the boron concentration in the field oxide and bird's beak regions by increasing the boron field implant. However, because the implants in the retrograde P-well CMOS process are performed after the field oxidation, they are much more effective in raising the boron concentration and hence the threshold voltage in these regions.

A 1.2 micron advanced VLSI CMOS process with the radiation hardening modifications described above has been employed by the instant assignee in the fabrication of both NMOS and PMOS devices. This is a retrograde P-well process with separate optimization of both the NMOS and PMOS devices. A P-well dark field mask was applied to form the retrograde well and adjust the NMOS voltage threshold using high and low energy boron implants. The retrograde P-well implant was performed with 350 keV boron ions after field oxidation, while the NMOS threshold voltage was adjusted with a 45 keV boron ion implant. A P-well clear field mask was used to adjust the PMOS threshold voltage. Phosphorous and boron implants were used for PMOS punch-through control and the PMOS threshold voltage adjust, respectively. The deep implant is referred to as a "punch-through control implant" because it eliminates source-to-drain breakdown. The 250 keV boron bird's beak implant was added to enhance the doping of the NMOS active area periphery. The purpose of the bird's beak implant is to suppress leakage currents along the channel edges after exposure to ionizing radiation. After implantation, a bird's beak etch was performed which etches about 1000Å to 2000Å of the field oxide. The gate oxide was then formed and has a thickness of 250Å. The gate electrodes were comprised of phosphorous-doped polysilicon deposited atop the gate oxide.

Lightly doped drain structures with sidewall oxide spacers were employed to improve the hot electron tolerance for 5 volt operation. N+ and P+ source/drain implants were performed with arsenic and boron fluoride ($BF_2$) ions, respectively. A first interlayer dielectric film was deposited and the first contact windows were opened in the source and drain regions. A molybdenum-titanium-tungsten multilayer metal film, hereinafter designated metal-1, was used to make contact to the N+ and P+ sources and drains. Following the deposition of a second interlayer dielectric film, aluminum, hereinafter designated the metal-2 layer, was deposited and patterned for interconnections and bonding pads. Test devices include linear PMOS and NMOS FETs at each dielectric level, as well as both annular and linear transistors at the active gate area. The field oxide and interlayer dielectric transistors were designated by the conducting runs used at that particular level; i.e., polysilicon, metal-1, and metal-2. Simple MOS capacitors were also used for a quick evaluation of the radiation hardness of some oxides following various implant steps. In these cases, oxide films of the desired thicknesses were grown thermally on silicon wafers which were then implanted with boron ions, as needed, followed by the deposition of polysilicon and aluminum. Both the aluminum and polysilicon were then patterned to form the capacitors.

An Accutest Process Evaluation Test System 3000, manufactured by the Accutest Corporation of Chelmsford, Massachusetts, was used to collect large quantities of parametric test data from the test dies on full CMOS wafers and to reduce these data to statistical form. This system is made up of a remote test head and a mainframe controller. The test head contains low-level switching and sensitive measurement circuitry. The mainframe contains the less sensitive instrumentation and the control circuitry. The parametric data for both NMOS and PMOS transistors of various channel lengths and widths include threshold voltage, channel mobility, punch-through voltage, junction breakdown, subthreshold leakage, and the like. Among these data, however, only those data which are affected by the radiation-hardening modifications described herein are of interest. A wafer level X-ray irradiation machine, the Model 4100 Semiconductor Irradiation System, developed by Advanced Research and Applications Corporation of Sunnyvale, California, and a gamma radiation source, the AECL GAMMACELL 220 source, which provides radiation from cobalt-60, and is obtainable from General Electric Company, Space Systems Division, Philadelphia, Pennsylvania, 19101, were used to irradiate the test devices.

Test devices made with a P-well implant dosage of $2x10^{13}$ ions/cm$^2$ and a bird's beak implant dosage of $2x10^{13}$ ions/cm$^2$ showed an improvement in radiation hardness of 20 kilorads to X-rays and 17 kilorads to gamma rays over a test device that was manufactured using only half of the P-well implant dose and none of the bird's beak implant. As a point of reference, the measured radiation hardness of the non-radiation hardened test device was 12 kilorads to X-rays and approximately 8 kilorads to gamma rays. A similar device processed with a bird's beak etch of 1500Å showed an improvement in radiation hardness of 36 kilorads to X-rays and 38 kilorads to gamma rays over the test device. A device processed with a bird's beak etch of 2000Å showed an improvement in radiation hardness of 68 kilorads to X-rays.

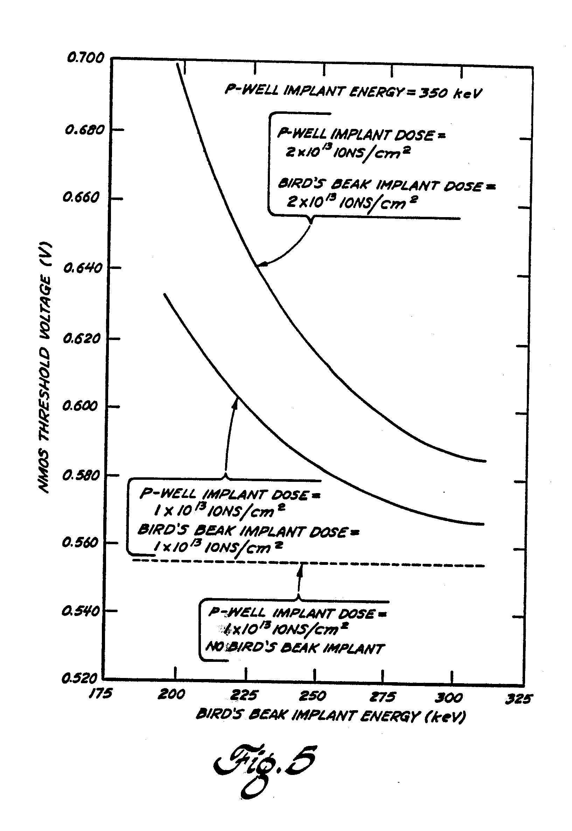

The threshold voltage changes as a result of the bird's beak implant were simulated as a function of implant dose and energy. A graph of the simulation is shown in Figure 5. For the implant energy of 250 keV and an implant dose of $2x10^{13}$ ions/cm$^2$, the n-channel threshold voltage in the active area is raised by only 30 millivolts, which is negligibly small.

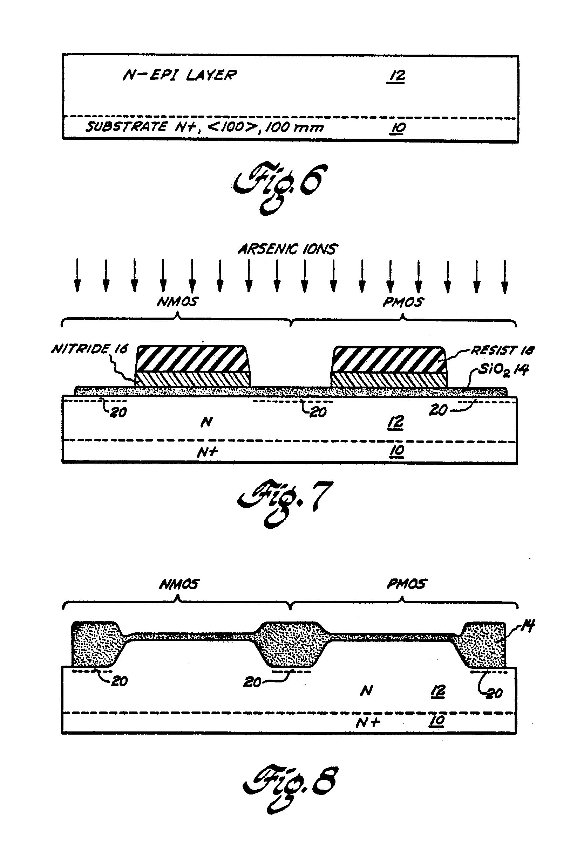

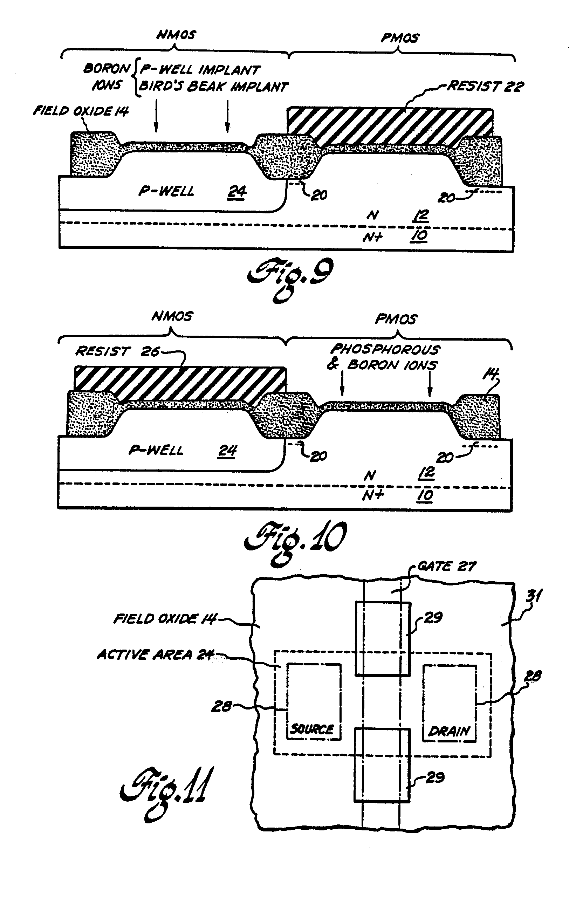

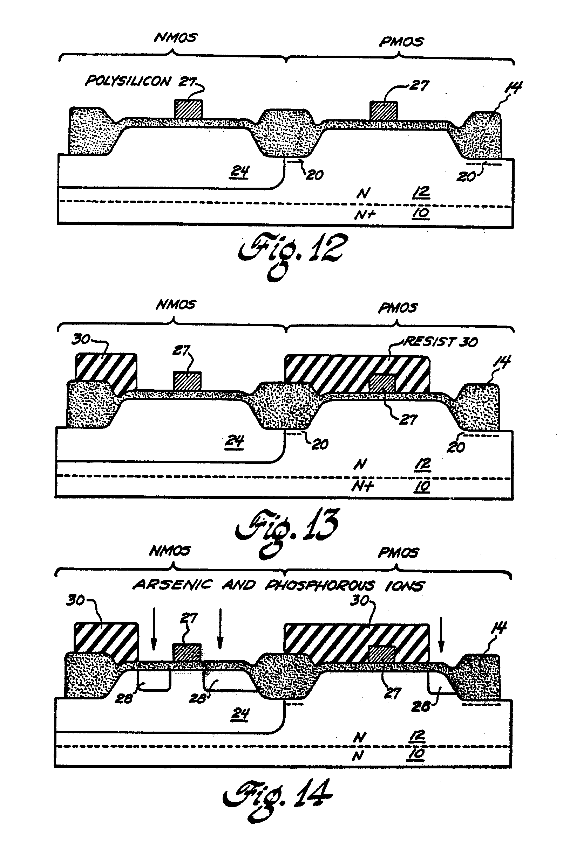

Figure 6 through 24 show the steps of the process thus described for making the CMOS test devices. The process employs, as a starting material, N/N+ pre-gettered epitaxial wafers, shown in Figure 6, which may be purchased from a silicon manufacturer. Substrate 10 comprises <100> N+ silicon and the N epitaxial layer 12 is situated on top of the substrate. As in the LOCOS process, a layer of silicon dioxide 14 is grown on the substrate for stress relief, then low pressure chemical vapor deposited (LPCVD) silicon nitride layer 16 is deposited on the substrate, as shown in Figure 7. A photoresist mask 18 is next placed on the LPCVD nitride 16. The mesa of resist 18 and nitride 16 cover the active regions and define the field oxide regions. Figure 7 shows the substrate with mesas for the NMOS area and PMOS area. The PMOS field threshold voltage is enhanced with a light dose of arsenic implant 20, which is applied unselectively to all field regions. Since the boron retrograde implant dose is twenty times larger than arsenic implant 20, its concentration overrides the arsenic implant in the NMOS field region, making the effect of the arsenic implant in the NMOS field threshold negligible. The arsenic implant step advantageously saves a PMOS field masking step. The field regions are then oxidized by a standard LOCOS process which incorporates radiation hardening techniques, such as ramping up the temperature in pure oxygen and avoiding nitrogen annealing after growth. After the growth of $SiO_2$ in the field regions, the layers of resist 18 and nitride 16 are removed by conventional techniques, leaving the structure shown in Figure 8.

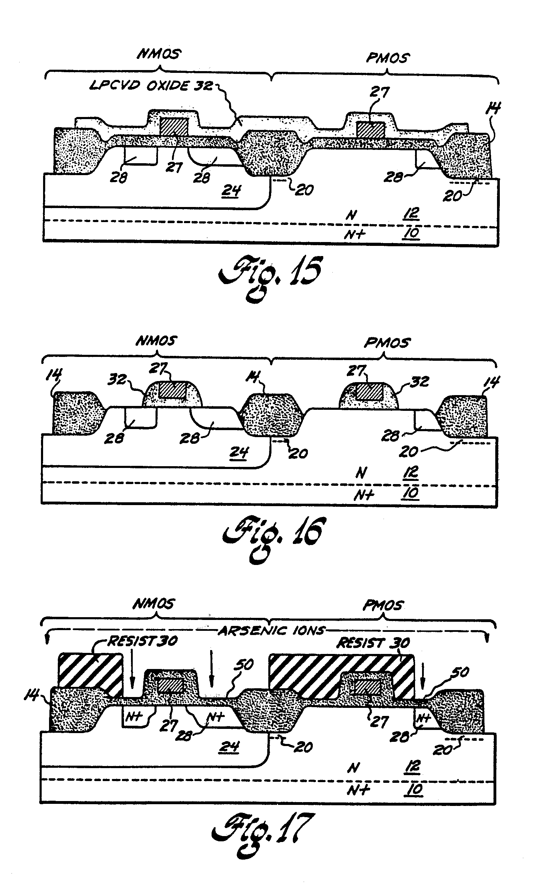

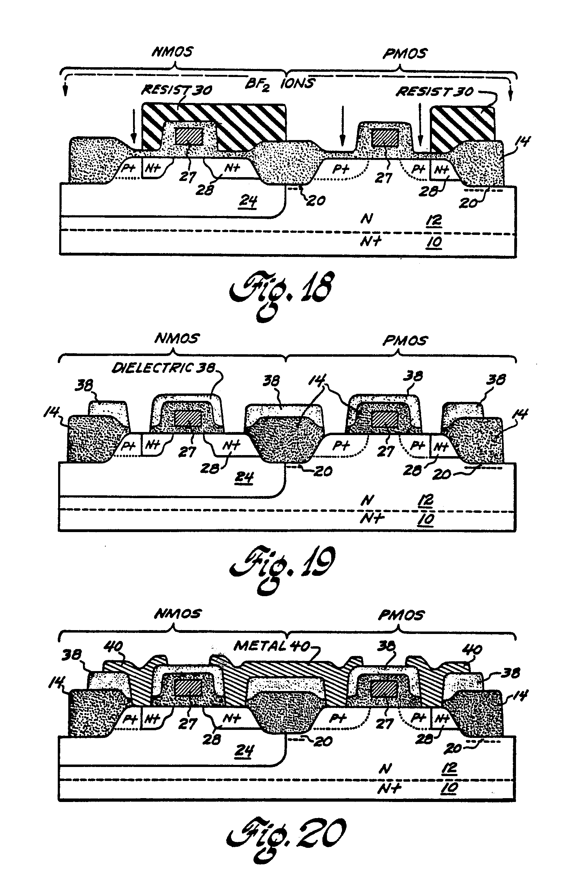

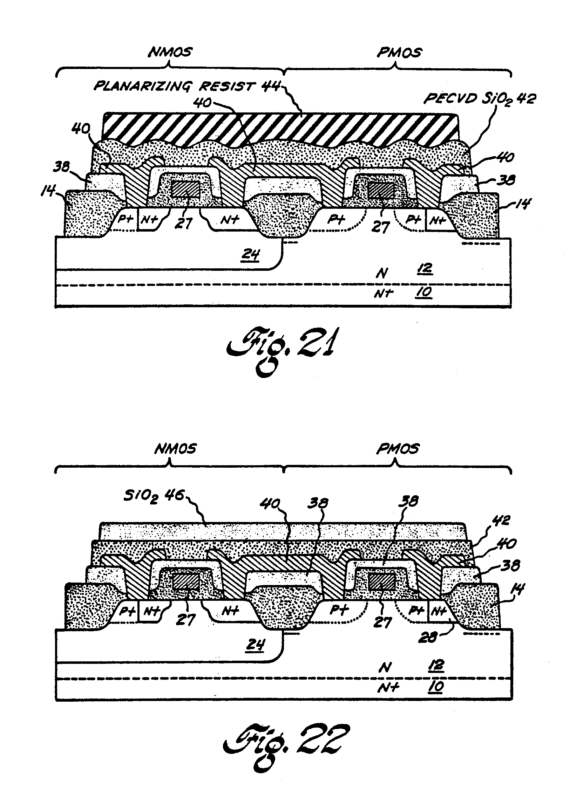

A P-well dark field photoresist mask 22 is next applied over the active PMOS region, as shown in Figure 9, in order to facilitate implantation of high and low energy boron ions in the NMOS area only. The boron implants are indicated in Figure 9 by vertical arrows. The retrograde P-well 24 results from the high energy boron ions. The bird's beak implant of intermediate energy boron ions is made thereafter, so as to raise the threshold voltage beneath the bird's beak region, as best indicated in Figure 2B. A bird's beak etch is next employed to increase the radiation hardness of the transistors by etching away 1000Å to 2000Å of the field oxide, as best shown in Figure 4. Mask 22 is then removed and a P-well clear field photoresist mask 26 is applied over the active NMOS region, as shown in Figure 10. The vertical arrows in Figure 10 indicate implantation of phosphorus and boron ions. The deep phosphorus implant is used for source-to-drain punch-through control. The low energy boron implants are used for threshold voltage control. Increased junction capacitance thereby occurs, due to the increased P-well dopant concentration resulting from the bird's beak implant. This increase in junction capacitance can be minimized by exposing only the bird's beak regions near the polysilicon gate to the bird's beak implant. This is accomplished by employing a mask layout 31, as shown in top plan view in Figure 11, which has an opening only in the areas 29 to be exposed to the bird's beak implant. Gate 27 and source and drain regions 28 to be formed are indicated in phantom.

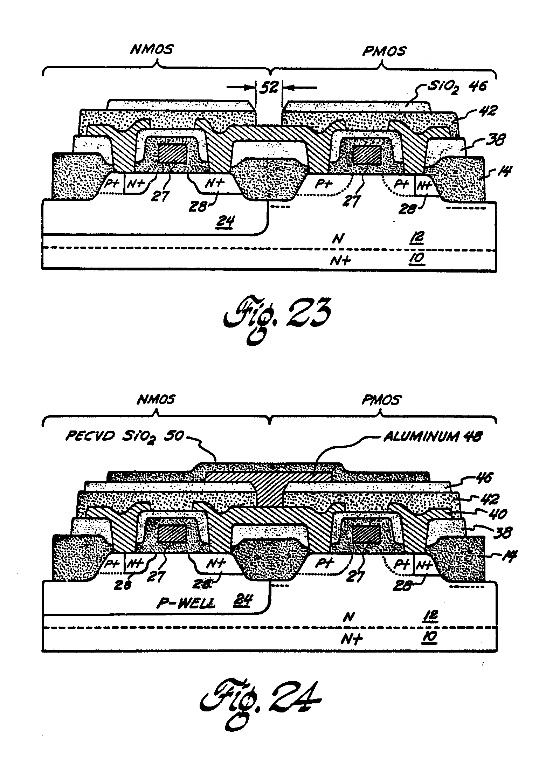

Polysilicon gates 27, shown in Figure 12, are next deposited in the active area and doped with trichlorophosphoric acid (POCl). Thereafter, as shown in Figure 13, resist masks 30 are applied to control the regions to be exposed to the arsenic and phosphorus ions. This ion implantation, which forms regions 28, is indicated by the vertical arrows in Figure 14. The energy of the ions is made as high as possible, consistent with avoiding penetration of these ions through the polysilicon gate.

After the ion implants, sidewall oxide spacers are formed on the edges of the polysilicon gates by first deposition a layer of silicon dioxide 32 on the structures by chemical vapor deposition (CVD) or low pressure chemical vapor deposition (LPCVD), as shown in Figure 15, and then reactive ion etching (RIE) all of the silicon dioxide except the sidewall spacers on gates 27 and the field oxide portions of layer 14, as shown in Figure 16.

A screen oxide 50 is next thermally grown on the device so as to coat, to a depth of about 250Å, the exposed silicon above the source and drain areas to be formed. The subsequence source and drain implants, as shown in Figures 17 and 18, are then performed using arsenic to form N+ regions and boron fluoride to form P+ regions, at low energy and high dose. Photoresist mask 34, shown in Figure 17, and photoresist mask 36, shown in Figure 18, are used in defining the source and drain implants in the NMOS and PMOS areas.

An interlevel dielectric 38 is next deposited at high temperature on top of the entire structure, and RIE is then used to etch contacts down to the silicon by the source and drain, resulting in the structure shown in Figure 19. The first metallization 40, comprised of molybdenum because it is resistant to electromigration and makes excellent ohmic contacts, is shown in Figure 20. The molybdenum layer is etched to provide separate, electrically-isolated conductor runs.

A second dielectric comprising a thick oxide layer applied by plasma enhanced chemical vapor deposition, overlaid with a spincoated photoresist 44 are next applied over the metallization, as shown in Figure 21. Resist layer 44 is applied over the second dielectric by spinning, and then is planarized by reflowing in a post bake. Spin coated resist 44 and second dielectric 42 are next etched at the same rate until all the resist is removed. As can be seen in Figure 22, the surface of second dielectric 42 is thereby planarized, and a surface layer 46 of silicon dioxide is then deposited to guarantee the minimum intermetal thickness when the next layer of metal is applied to the device.

Vias are RIE etched by a process resulting in a semitapered opening to improve step coverage of the second metallization. Figure 23 shows the structure which is produced by lithographically applying a layer 46 of photoresist, and two-step etching of a via 52 by RIE etching through resist layer 46 and dielectric layer 42 with a straight profile of diameter 52, followed by a tapered profile through resist layer 46 only. The second metallization is a DC magnetron-sputtered aluminum 48, as shown in Figure 24. The completed device, shown in Figure 24 as it is before it is packaged, undergoes final processing after aluminum 48 is applied, which comprises RIE etching of a protective coating of silicon dioxide 50 thereon. The processes thus practiced in the invention conform to the techniques employed in known advanced VLSI processes, and require no extra masking steps.

While the invention has been described in terms of preferred embodiments which incorporate a bird's beak implant or a combination of such implant with a bird's beak etch, those skilled in the art will recognize that the specific doses and parameters may be varied in the practice of the invention within the spirit and scope of the appended claims.

**Claims**

1. A process for radiation hardening very large scale integrated circuits including metal oxide silicon devices produced using a retrograde P-well process, comprising the steps of: forming a local oxidation of silicon field isolation for each of said devices, said local oxidation producing a bird's beak structure;

implanting boron ions in the region of the bird's beak structure; and

etching the field oxide to remove a portion of the bird's beak structure.

2. The process for radiation hardening recited in claim 1 wherein the step of implanting is performed using boron ions having an energy of approximately 250 keV to produce an implant dose of approximately $2 \times 10^{13}$ ions/cm$^2$.

3. The process for radiation hardening recited in claim 1 wherein the step of etching removes 1000Å to 2000Å of a field oxide to form a self-aligned guard ring with a higher threshold voltage.

4. The process for radiation hardening recited in claim 2 wherein the step of etching removes 1000Å to 2000Å of field oxide to form a self-aligned guard ring with a higher threshold voltage.

5. A process for radiation hardening an NMOS semiconductor device comprising the steps of:

forming a local oxidation of semiconductor to provide field isolation for said device, said local oxidation producing a bird's beak structure including a tip;

implanting boron ions in the region of the bird's beak structure including the tip; and

removing a portion of the bird's beak structure including the tip.

6. The process for radiation hardening recited in claim 5 wherein said semiconductor comprises silicon and the step of implanting is performed using boron ions having an energy of approximately 250 keV to produce an implant dose of approximately $2 \times 10^{13}$ ions/cm$^2$.

7. The process for radiation hardening recited in claim 5 wherein the step of etching removes 1000Å to 2000Å of field oxide to form a self-aligned guard ring with a higher threshold voltage.

8. The process for radiation hardening recited in claim 6 wherein the step of etching removes 1000Å to 2000Å of field oxide to form a self-aligned guard ring with a higher threshold voltage.

**FIELD OXIDE** — **BIRD'S BEAK** — **POLY GATE**

② ③ ①

ACTIVE AREA — ACTIVE AREA

SOURCE — DRAIN

N+ — N+

P-WELL

BIRD'S BEAK — GATE OXIDE — FIELD OXIDE

*Fig. 1*

Fig. 2A

Fig. 2B

0273702

**Fig.3**

**Fig.4**

Fig.5

| | |
|---|---|
| N-EPI LAYER | *12* |
| SUBSTRATE N+, <100>, 100 mm | *10* |

*Fig. 6*

ARSENIC IONS

↓ ↓ ↓ ↓ ↓ ↓ ↓ ↓ ↓ ↓ ↓ ↓ ↓ ↓ ↓

NMOS          PMOS

NITRIDE 16     RESIST 18
               SiO₂ 14
20      N      20      *12*      20
N+      *10*

*Fig. 7*

NMOS          PMOS

14
20      20      N      *12*      20
N+      *10*

*Fig. 8*

0273702

NMOS                    PMOS

BORON { P-WELL IMPLANT
IONS  { BIRD'S BEAK IMPLANT          RESIST 22

FIELD OXIDE 14

P-WELL      24        20          20

N        12
N+       10

Fig.9

NMOS                    PMOS

RESIST 26              PHOSPHOROUS
                      & BORON IONS        14

P-WELL      24        20          20

N        12
N+       10

Fig.10

GATE 27

FIELD OXIDE 14                          31
                              29
ACTIVE AREA 24                          28

28          SOURCE        DRAIN

Fig.11                        29

0273702

NMOS                                              PMOS

POLYSILICON 27                          27                    14

24          20                              20
N        12
N+       10

*Fig. 12*

NMOS                                              PMOS

30              27                          RESIST 30        14

24          20                              20        27

N        12
N+       10

*Fig. 13*

NMOS                                              PMOS

ARSENIC AND PHOSPHOROUS IONS

30              27              30                          14

28          28              24              27      28

N        12
N        10

*Fig. 14*

0273702

NMOS · PMOS

LPCVD OXIDE 32 · 27 · 14 · 28 · 27 · 28 · 24 · 20 · 28 · 20 · N · 12 · N+ · 10

Fig. 15

NMOS · PMOS

14 · 32 · 27 · 14 · 27 · 32 · 14 · 28 · 28 · 24 · 20 · 28 · 20 · N · 12 · N+ · 10

Fig. 16

NMOS · PMOS

ARSENIC IONS

RESIST 30 · RESIST 30 · 50 · 14 · N+ · 27 · 28 · N+ · 24 · 20 · 27 · N+ · 28 · 20 · 50 · N · 12 · N+ · 10

Fig. 17

NMOS    PMOS

RESIST 30    BF₂ IONS    RESIST 30

*Fig. 18*

NMOS    PMOS

DIELECTRIC 38

*Fig. 19*

NMOS    PMOS

METAL 40

*Fig. 20*

0273702

NMOS                                    PMOS

PLANARIZING RESIST 44
40                                      PECVD SiO₂ 42
40                                      40
38                                      38
14                                      14

P+  N+  27  N+        P+  27  P+  N+

24

N    12
N+   10

*Fig. 21*

NMOS                                    PMOS

SiO₂ 46        40    38        38
                                        42
                                        40
                                        38
                                        14

P+  N+  27  N+        P+  27  P+  N+

24                                      28

N    12
N+   10

*Fig. 22*

0273702

Fig. 23

Fig. 24